# EUROPEAN PATENT SPECIFICATION

(11) **EP 4 177 968 B1**
(45) Date of publication and mention of the grant of the patent: **26.03.2025**
(21) Application number: 21206307.7
(22) Date of filing: 03.11.2021
(51) Int. Cl.: H10F 77/42, H02S 20/32

(54) **OPTOMECHANICAL SYSTEM TO REGULATE LIGHT TRANSMISSION AND ELECTRICITY PRODUCTION**
OPTOMECHANISCHES SYSTEM ZUR REGULIERUNG VON LICHTÜBERTRAGUNG UND STROMERZEUGUNG
SYSTÈME OPTOMÉCANIQUE POUR RÉGULER LA TRANSMISSION DE LUMIÈRE ET LA PRODUCTION D'ÉLECTRICITÉ

(43) Date of publication of application: 10.05.2023
(73) Proprietor: Insolight SA, 1020 Renens (CH)
(72) Inventor: Gerlich, Florian, CH-1012 Lausanne (CH); Coulot, Laurent, CH-1003 Lausanne (CH); Ackermann, Mathieu, CH-1006 Lausanne (CH); Bory, Noé, CH-1003 Lausanne (CH); Nardin, Gaël, CH-1027 Lonay (CH); Schuppisser, David, CH-1007 Lausanne (CH); Ziegler, David, CH-1023 Crissier (CH)
(74) Representative: BOVARD AG

(56) References cited:
- US-A1- 2010 224 231
- US-A1- 2012 037 204
- US-A1- 2014 090 687

## Description

### Technical Field

The present invention relates to the technical field of optical systems, more specifically to the technical field of optomechanical systems and a control system thereof to regulate light transmission and electricity production as well as to control synchronization of one or more optomechanical systems. More precisely, the present invention relates to an optomechanical system and a control system thereof, which allow for high efficiency conversion of light energy of direct incident light or transmission of the diffuse incident light to match the requirements for growing conditions of plants underneath the optomechanical system. Such optomechanical systems can in particular be used in an advantageous way in the construction of solar panels with adjustable transparency for the field of agrivoltaics.

### Background of the invention

More and more, photovoltaic plants and agriculture are competing for land usage. Due to their relatively low energy conversion yield, both processes require very large open spaces with similar features such as decent amount of solar irradiance, relatively flat ground with minimal shading or obstacles, reasonable proximity with urban areas to alternatively produce electricity or grow food. Therefore, there is a strong incentive for an invention allowing both activities to take place on the same land.

Furthermore, there is an interest in producing renewable electricity locally which can be used in energy intensive agricultural processes. For instance, the energy can be used to power heating or cooling systems, pumps for irrigation, etc.

Additionally, reducing the amount of direct incident light on the crops in warmer climates can also decrease their irrigation needs. On a greenhouse, decreasing the irradiance can reduce or even remove the need for cooling systems.

Installing conventional silicon photovoltaics (PV) modules above crops or greenhouses is one solution. Conventional PV modules are very cheap and can be produced in mass. They are, however, completely opaque and therefore shade the plants placed below them if they are not sufficiently spaced. Nevertheless, spacing them apart is not very effective, as it results in a decrease of the electricity production, as well as in a non-homogeneous illumination of the crops, with shadows moving throughout the course of the day. In this manner, the land may be shared but the overall utilization of sunlight per unit area is not significantly increased.

Another solution is to use translucent solar cells, such as organic cells, which can provide high level of translucency, specifically high light transmission. However, these technologies typically achieve very low efficiencies - well below 10% - and suffer from stability issues when exposed to harsh environments.

Alternatively, the solar modules can be mounted on a rotating sun tracker, which are typically mounted in such a way to rotate the modules along either the east-west and/or the north-south axis. The amount of light impinging on the crops below the solar module can be adjusted by rotating the tracker in order to move the solar module shadow towards or away from the crops. The orientation control of the solar modules are known as solar tracking by means of a tracking system. This tracking system can effectively adjust the amount of light provided to the crops by either exposing the crops to full sunlight or to shadow. However, no intermediate illumination is provided. Moreover, in order to efficiently shade the crops below them, the trackers must typically have a wide angular range in particular at least +/- 60°, which requires significant spacing between rows of trackers, as well as sufficient height to avoid impeding the agricultural work below by either men or machines. Due to their size and weight these systems are not compatible with greenhouse structures or rooftop installations. Additionally, due to the large spacing between rows of trackers, the crops are poorly protected from harsh weather events such as heavy rain and/or hail.

Patent publication US 2014/090687 A1 discloses a dual glazing insulated glass photovoltaic skylight system comprising a first substrate with a lenticular array and solar cells disposed on a second glass substrate. A slide mechanism provides lateral relative movement between first and second substrates.

For the above reasons, there is a need for an optomechanical system and a tracking system, which allow for high efficiency conversion of light energy and adjustable light transmission to match the amount of daylight required by the plants beneath, wherein the tracking system moves only within a limited volume, in order to track the apparent movements of the sun while still ensuring compatibility with typical agronomic structures such as greenhouses, plastic tunnels or roof gardens.

### Summary of the invention

Thus, the object of the present invention is to propose a new optomechanical system and a tracking system for converting and transmitting light energy, as defined in claim 1, in which the above-mentioned drawbacks of the known systems are completely overcome or at least greatly diminished.

Objects of the present invention are in particular to propose an optomechanical system including optical layers and light collection layers with photovoltaic cells and a low-profile, low-deflection tracking system to control the collection and transmission of direct sunlight, thanks to which it is possible to control the amount of sunlight collected to produce electricity and the amount of sunlight transmitted to the crops beneath for photosynthesis in a finely regulated manner.

Specifically, the invention enables a precise control of light transmission to match the requirements of the crops growing underneath the installed optomechanical system. The precise control of light transmission through the optomechanical system can be adjusted continuously and instantaneously based on various types of manual inputs of an end-user, or automatically based on a schedule or a light control algorithm with various input parameters. Such parameters including - but not limited to - temperature, humidity, irradiance, daily light integral, electrical power, electrical current or voltage, can be used to finely adjust the balance between the amount of light energy used for power generation and the amount of light energy transmitted to the crops.

Furthermore, the invention enables to precisely control the amount of light converted into electricity at any time. By increasing the amount of light transmission for lighting, the amount of light focused on the photovoltaic cells is reduced. In order to advantageously balance the load of an electric grid, it is preferrable to produce more energy at times of higher demands such as in the morning and in the evening. Another advantage of the energy production adjustment is that the produced energy can be injected into the electrical grid when energy prices are higher.

By providing a relatively low amplitude of movement, the optomechanical system is compatible with many types of agrivoltaic installations and setups. For example, the optomechanical system can replace plastic tunnels above line cultures such as berries, or it can be integrated directly into greenhouse roofing, or mounted onto rooftop structures to combine urban farming and energy conversion.

According to the present invention, these objects are achieved in particular through the subject-matter of independent claim 1. Further advantageous embodiments arise from the dependent claims and the description. Features disclosed herein in different embodiments can also be combined easily by a person who is skilled in the art.

In particular, in a first aspect, the objects of the present invention are achieved by an optomechanical system for converting light energy, specifically to convert or transmit the light energy of a direct component of incident light such as sunlight while transmitting a diffuse component of the incident light through the optomechanical system and means to regulate light transmission and electricity production. The optomechanical system to regulate light transmission and electricity production, in particular in the field of agriculture, comprising
- an optical arrangement with a plurality of optical layers, wherein each optical layer comprises multiple optical elements configured to focus a direct component of incident light and transmits a diffuse component of incident light;
- a light collection arrangement with a plurality of light collection layers, wherein each light collection layer is at least partially translucent to light and comprises multiple distant elongate photovoltaic cells arranged in rows and spaced by gaps;
- at least one or more guiding elements, attached to the optical arrangement and/or the light collection arrangement, capable of providing a relative translation and suppressing any rotation between the optical arrangement and the light collection arrangement;
- a centralized tracking system configured to either displace the optical arrangement or the light collection arrangement along at least one axis such that at least part of a direct component of incident light is directable onto the photovoltaic cells of the light collection arrangement and at least a part of a diffuse component of incident light is transmittable through the gaps between the rows of the photovoltaic cells;
wherein the tracking system is configured to displace translationally, along a circular or quasi-circular trajectory, either the optical arrangement or the light collection arrangement such that the amount of the direct component of the incident light focused on the photovoltaic cells and the amount of the direct component of incident light transmitted through the optomechanical system is adjustable.

Of course, the optomechanical system of the invention also comprises a static structure, anchored to the ground, to which the optical arrangement and/or the light collection arrangement is attached. This static structure serves as a basis for physically supporting the optomechanical system and its components.

Thanks to the present invention, it is possible to efficiently convert light energy of the direct component of the incident light such as sunlight into electricity while transmitting at least a part of the diffuse component of the incident light through the optomechanical system. The combination of an optical layer designed to concentrate at least part of incident light onto respective light collection elements and a low-profile and low-deflection tracking system to control the collection and the transmission results in an effective optomechanical system.

The energy generation due to light collection by the photovoltaic cells depends on the amount of incident light which changes over the day depending on the movement of the sun relative to the optomechanical system. The tracking system of the optomechanical system can be used to move either the optical arrangement or the light collection arrangement in order to modulate and control the amount of light energy converted by the photovoltaic cells and the amount of light transmitted through the system. In particular, with the tracking system configured as a dual-axis tracking system, it is possible to place the photovoltaic cells always at the most favourable position relative to the optical elements of the optical arrangement to maximize the production of energy.

It is important to understand that the centralized tracking system can be used as well to maximize the amount of transmitted light through the optomechanical system and therefore to maximize the amount of light impinging on the plants placed below the optomechanical system in order to favour their growth. In particular, the centralized tracking system can be used to move the optical arrangement and the light collection arrangement relatively in order to intentionally misalign the optical layers relative to the light collection layers, and to transmit a greater amount of light than the sole amount of the diffuse component of the incident light to the plants. This is favourable when the plants need more irradiance than that of the diffuse sunlight alone over the day. In particular, when the sun is low, this option is advantageous. Balancing the amounts of the two possibilities to use the sunlight provides the mentioned advantages. Therefore, the centralized tracking system is programmable to follow not only the movements of the sun throughout the sky but to adjust the amount of electricity production and light transmission. More generally, the optomechanical system can provide a programmable centralized tracking system configured to misalign the optical arrangement relative to the light collection arrangement at any time during the day, e.g. based on manual inputs or feedback of one or more sensors. Specifically, the optomechanical system according to the present invention provides precise control of the amount of transmitted light to match requirements of the plants or crops growing underneath.

Advantageously, the amount of transmitted light can be adjusted almost instantaneously by an end-user or automatically based on various feedbacks and/or parameters. These parameters are for example a daily light integral requirement of the crops or plants, an irradiance level above or below the optomechanical system, an ambient temperature, relative humidity and/or any combination thereof. These parameters can be used as input parameters to a light control algorithm usable for the automatic control of the amount of transmitted light.

In the present invention, the at least one guiding element is configured to guide the movement of the optical arrangement or the light collection arrangement along a circular or a quasi-circular trajectory, such as a paraboloid trajectory, while suppressing any relative rotation between the optical arrangement and the light collection arrangement. A curved displacement trajectory is advantageous to increase the efficiency and/or angular acceptance of the optomechanical system.

In a preferred embodiment of the present invention, the guiding elements are capable of guiding the movement of the optical arrangement relative to the light collection arrangement and capable of supressing relative rotations between the optical layer arrangement and/or the light collection arrangement. More specifically, the at least one guiding element can be designed as a double low-friction hinge for a single-axis movement, and/or as double universal joint and/or as double ball-joint for a dual-axis movement. By limiting the degrees of freedom of the translated elements, e.g. the optical arrangement and/or the light collection arrangement, the relative position of the optical arrangement and the light collection arrangement can be accurately adjusted by the tracking system and more specifically rotations can be avoided or minimized. This is important since any minimal rotational movement between any pair of optical layer and light collection layer decreases the output power and light transmission capability of the system.

Alternatively, the at least one guiding element can be designed as a flexible guiding element. Guiding based on mechanical deformation is advantageous for mechanical systems requiring high reliability and long lifetime. Furthermore, the precision of flexible guiding elements in carrying out small displacements without involving friction or wear qualify them for the optomechanical system.

In a preferred embodiment, the at least one guiding element is attached directly to the optical arrangement or the light collection arrangement, in particular between an optical layer and a light collection layer. The direct mechanical link provided by these guiding elements ensures an accurate positioning of the two layers relative to each other. The positioning of any pair of layers ensures that at least one photovoltaic cell lies in a focal point or spot location of a corresponding optical element of the optical layer independently of the angle of incidence of the direct incident light. The hinges can be directly attached to the optical arrangement or the light collection arrangement for example as being accommodated and held through holes machined in one of the arrangements ensuring an accurate positioning. In an embodiment, the at least one guiding element can be designed as a rail and can be configured to guide the movement of the optical arrangement or the light collection arrangement along a trajectory in a plane. Such a configuration is advantageous in that it allows for a precise movement without using a lot of force.

In another preferred embodiment of the invention, the light collection layer is indirectly attached to a corresponding optical layer by means of the guiding elements and an intermediate frame element. In this embodiment the optomechanical system comprises a frame, wherein multiple optical layers and/or multiple light collection layers are attached together by the frame or attachment element, and wherein the at least one guiding element is connected to the frame or attachment element on one end, and to the optical arrangement or the light collection arrangement on the other end. The frame can be seen as a platform which would hold the elements of the optomechanical system together and may serve as an interface between the optomechanical system and the tracking system. The dimensions of the frame could be selected so that it would not bend under the weight of the tracking system and the optical layers, but would also supply a larger part for attachment of the tracking system and/or guiding elements.

In yet another embodiment of the present invention, the centralized tracking system is configured as a single axis or a dual-axis tracking system to which the optomechanical system is attached. Therefore, the tracking system is provided to displace the optical arrangement, the light collection arrangement, or the frame along at least one axis, preferably along two axes through tracking means.

Advantageously, the centralized tracking system further comprises at least one actuator and a control system such that the optical arrangement or the light collection arrangement can be moved in one or more degrees of freedom in a translational movement. Higher degrees of freedom in translation allows for increasing the accuracy and sensitivity of the optomechanical system, so that energy generation or light transmission can be optimized.

In one preferred embodiment of the present invention, the centralized tracking system comprises at least one elongated rod as a translation element connected to one or more of the optical layers or the light collection layers, such that the movement of the rod results in a relative translation between the optical arrangement and the light collection layers, for example either by pushing or pulling, or via a rack and pinion system. In this embodiment, double ball joint elements can be used as connecting elements. In this manner, the translation of the rod is translated into a quasi-circular trajectory of the elements of the optomechanical systems. At least one actuator creates a translation of the elongated rod either by directly pushing or pulling on it, or via a rack and pinion system which translates the rotation of the actuator into a translation of the rod. The at least one actuator is controllable by a control system to adjust the relative position of the optical arrangement and the light collection arrangement, in order to finely control the amount of light harvested by the light collection arrangement to produce electricity and the amount of light transmitted through the light arrangement to the crops. The at least one elongated rod can in particular run along at least one axis below the light collection arrangement.

In another embodiment of the present invention, the centralized tracking system is designed as a cable and pulley system, such that pulling the cable in either direction results in a relative translation between the optical arrangement and the light collection arrangement. The cable and pulley system can be connected by at least one connecting element to each optical layer of the optical arrangement or each light collection layer of the light collection arrangement. The translational movement is guided on a trajectory set by the guiding elements. In a further preferred embodiment of the present invention, the cable and pulley system is actuated by at least one actuator which is configured to wind and unwind the cable to produce a translation movement in either directions.

In another embodiment of the present invention, the centralized tracking system is configured as a pulley and belt system. The pulley and belt system can be connected by at least one connecting element to the optical arrangement or the light collection arrangement such that moving the belt in either direction results in a relative translation between the optical arrangement and the light collection arrangement. The pulley and belt system is configured to transfer movement from a rotating pulley to the belt such that the translation of the optical arrangement or the light collection arrangement is provided. The pulley and belt system can be adapted to the requirements of the optomechanical system, in particular by choosing a suitable pulley diameter and/or a suitable belt length in relation to the force required to actuate the system and the required stroke on each axis.

In another preferred embodiment of the present invention, the centralized tracking system is configured as a rod assembly system with at least one rotation axis activated by at least one actuator and at least one connecting rod, preferably a plurality of connecting rods, arranged to connect the rotation axis with the optical arrangement or with the light collection arrangement. By rotating the rotation axis in either direction, the rotation thereof is transformed into a translation between the optical arrangement and the light collection arrangement due to the connecting rod. The rotation of the rotation axis can be activated and controlled by the at least one actuator arranged at one end of the rotation axis.

In certain embodiments of the present invention, at least one actuator is configured to control the relative translation movement of the optical arrangement with a plurality of optical layers or the light collection arrangement with a plurality of light collection layers including the elongate photovoltaic cells. The at least one actuator may be an electro-mechanical actuator, an electro-static actuator, a piezo-electrical actuator, a sick-slip actuator, or a pneumatic actuator.

According to an aspect of the present invention, the optomechanical system comprises multiple modules including each an optical layer and a correspondent light collection layer forming the optical arrangement and the light collection arrangement which are moved relative to each other by the centralized tracking system with one actuator. The movement of the multiple modules must be synchronized to ensure a precise positioning of each light collection layer with reference to its corresponding optical layer and vice versa.

In one preferred embodiment of the present invention, wherein the multiple modules are connected by connecting elements to the translation elements such as a common cable, belt or rod of the centralized tracking system actuated by one single actuator, the connecting elements configured to automatically detach from the centralized tracking system above a certain level of force or at a predefined position, for instance when they reach a mechanical stop. In this embodiment the connecting elements can be designed as a hinge incorporating a clamping mechanism that unclamps automatically from the common cable, belt or rod when the modules reach a predefined position or a pre-defined level of force. For example, when the tracking means are pulled continuously by the at least one actuator in one direction, the clamping mechanism of each module opens at a defined inclined position of the connecting element, such that each module, in particular each pair of optical layer and light collection layer, has the same predefined position. Each module stuck in the predefined position until the at least one actuator reverses the movement of the translation elements. Thanks to this system multiple modules of the optomechanical system connected together by the tracking means such as a common cable, belt, or rod, can take the same position in a synchronized manner. This embodiment is advantageous to ensure a coordinated movement and accurate positioning of all modules connected to the centralized tracking system.

The connecting element can be configured in different ways to provide a clamping mechanism or clutch mechanism. In one preferred embodiment of the present invention, the clamping mechanism is configured such to open the connection or attachment to the common cable once a certain position is reached.

In another alternative embodiment of the connecting element a blocking system is provided to block the movement of the connecting element at a predefined position of the module, at which point the common cable, belt, or rod starts slipping in the clutch means. To reduce or control friction between the clutch means and the common cable, belt, or rod materials of the common cable, belt, or rod on one hand and of the clutch surfaces of the clutch mechanism on the other hand must be chosen carefully.

According to another embodiment of the present invention, the synchronization of multiple optomechanical systems can be provided by a discrete link in which each of the multiple modules of the optomechanical system can only latch onto at a specific position.

In another preferred embodiment of the present invention, the centralized tracking system of the optomechanical system comprises a control system to pilot the movement of the tracking system in order to adjust the amount of direct light focused on photovoltaic cells and the amount of direct light transmitted through the optomechanical system. In other words, the control system allows to adjust the amount of light energy used for energy production and for lighting. This adjustment can be performed in a semi-manual manner, by inputting target values into a user-interface, or in a fully automated manner, based on various input parameters such as sun position models, weather forecasts, predefined schedules or sensor inputs.

In a further embodiment of the present invention, the control system further comprises a feedback loop to monitor the power output of a string of modules, based on at least one sensor such as a current sensor. Based on this feedback loop, the control system can optimize the relative position of the optical arrangement and the light collection arrangement to either maximize or minimize electrical power output or to achieve any intermediate electrical power output value.

In a further embodiment of the present invention, the optomechanical system of the invention further comprises a feedback control loop to monitor the position of the multiple modules, wherein the feedback control loop is for example an optical sensor or other type of sensors. The one or more sensors can report information on the absolute position and/or of the relative position of the tracking means, the optical arrangement or the light collection arrangement or a combination thereof.

In yet another embodiment of the present invention, the centralized tracking system of the optomechanical system comprises the control system to control movement of the tracking system such to adjust the amount of the direct component of incident light focused on photovoltaic cells and the amount of the direct component of incident light transmitted through the optomechanical system or in particular the amounts of light energy used for energy generation and for lighting. The control system can be configured as a passive or active control system. Active means that the tracking system uses sensors or predetermined data to find the current position of the sun and actively orient the optomechanical system. Therefore, the control system could be programmable based on manual inputs through a user interface or other correspondent elements and/or based on external inputs such as feedbacks based on a variety of parameters such as weather forecast, or meteorological models, pre-defined schedules or based on values detected by at least one sensor. Preferably more than one sensor is provided whereby the sensors are configured to measure parameters which can be entered to the control system as external inputs or can be extracted from a memory unit. These parameters may be derived from sensors such as light sensors, temperature sensors, humidity sensors and/or wind speed sensors or a combination thereof. These parameters are capable to adjust the transmission of light through the optomechanical system to fulfil the requirements of the plants growing beneath the optomechanical system.

In another embodiment of the present invention, the feedback loop of the control system includes one or more sensors providing feedback on environmental variables and crop growth conditions, such as light sensors, humidity sensors, sap flow sensors and/or wind speed sensors, or a combination thereof. This is advantageous to ensure that the optomechanical system can adjust light transmission to achieve optimal growth conditions for the crops cultivated below.

In another aspect of the present invention, the optomechanical system is configured to be integrated into a so-called Venlo-type greenhouse roofing and/or to be mounted onto a rooftop structure. Preferably, the optomechanical system is dimensioned, in particular its width and length, to match standard pitches between two Venlo-type greenhouse chapels. The thickness of the optical arrangement is also adjusted to match glass plane thicknesses compatible with standard clamping systems of such greenhouses. One optomechanical system can be integrated on one or both sides of each chapel of the Venlo-type greenhouse roofing. In this embodiment of the present invention, water condensation can be collected by gutters on both ends of the optomechanical systems to ensure that water will not drip on crops below the optomechanical systems. This embodiment is advantageous to reduce the costs and/or complexity of the supporting structure by using off-the-shelf components, mass-produced components, which are already optimized and validated for this usage.

If the greenhouse is mostly orientated in north-south direction, optomechanical systems can be integrated on both roof sections, in particular on the east and west facing roof sections. This is advantageous to achieve a very high ratio of optomechanical system per meter square of ground and therefore to maximize energy generation and control of light transmission.

If the greenhouse is mostly orientated along an east-west axis, the optomechanical systems are preferably integrated on the south-facing roof sections, while the north-facing roof sections may be covered with conventional greenhouse glass panes. This is advantageous to maximize the energy generation since the optomechanical systems are oriented towards the sun. In a further embodiment, where the greenhouse is mostly orientated along an east-west axis and located in an area with high levels of irradiance (such as the south of Europe or north of Africa), the glass panes on the north-facing roof section can be advantageously replaced by static photovoltaic modules with a pre-defined density of photovoltaic cells (or predefined transparency level), in order to increase the energy generation per meter square of ground and reduce the amount of light transmission. In a preferred embodiment, the density of photovoltaic cells or the transparency level of the static photovoltaic modules is close to 50%.

Each light collection layer of the light collection arrangement of the optomechanical system comprises elongate photovoltaic cells arranged in substantially parallel rows. The stripes are spaced from each other by gaps or spaces providing translucent regions for transmitting light for the photosynthesis of plants or crops growing beneath the optomechanical system. In a preferred embodiment of the present invention, each light collection layer of the light collection arrangement includes a plurality of elongate photovoltaic cells arranged in a bi-dimensional array of substantial parallel rows whereby each elongate photovoltaic cell has a ratio between length and width greater than 4:1.

In yet another embodiment of the present invention, the gaps between parallel rows of the arranged elongate photovoltaic cells are at least 30% of the width of the elongate photovoltaic cell.

In a further embodiment of the present invention, the solar cells or photovoltaic cells of each light collection layer are interconnected by connection lines such as ribbons, bus bars, or etched conductive sheets provided on the light collection layer. This arrangement of solar cells and connection lines forms a conductive circuit onto which the solar cells are interconnected. Thanks to a combination of series and parallel connections of the multiple elongate photovoltaic cells forming an arrangement on each light collection layer, the voltage and current output of the optomechanical system can be optimized.

In a preferred embodiment of the present invention, the connection lines are arranged along the length of the elongate photovoltaic cells to minimize shading between rows of the arrangement of the elongate photovoltaic cells and therefore optimize light transmission to the plants growing underneath the optomechanical system.

Furthermore, the connection lines may be provided at the back side of the elongate photovoltaic cells to minimize shading on the front side of the solar cells and therefore to optimize light collection and electricity production.

In another embodiment of the present invention, the connection lines are made out of transparent conductive material, such as a transparent conductive oxide. This is advantageous to guarantee that the light absorbed by the connection lines is minimal to ensure that the maximum of light not captured by the light collection elements is transmitted through the optomechanical system. The light collection elements of the light collection arrangement can be of different types. For example, each light collection element may be designed as single junction solar cells, such as poly- or mono-crystalline silicon cells. These can be for instance common types of mono-silicone solar cells with a good performance-to-cost ratio such as Passivated Emitter and Rear Cell (PERC) or Passivated Emitter or Rear Totally Diffused (PERT) cells, thin-film solar cells such as Copper Indium Gallium Selenide (CIGS), Cadmium Telluride (CdTe) or amorphous silicon, which are mass produced at very low cost, or more recent technologies such as Tunnel Oxide Passivated Contact (TOPCON). The solar cells can also be made from alternative materials such as perovskite solar cells or perovskite-silicon tandem solar cells. Multijunction solar cells based on III-V materials such as Gallium-Arsenide (GaAs) can also be used advantageously to achieve higher efficiencies and power densities.

In another embodiment of the present invention, the light collection elements are rear contact cells such as interdigitated back contact (IBC) solar cells. These types of solar cells are advantageous because they minimize shading on the front side of the light collection element and therefore increase the light conversion efficiency of the light conversion arrangement.

In another preferred embodiment of the present invention, the light collection elements are bifacial solar cells able to collect the light reflected from the ground to maximize the electricity production. In this embodiment, the ground in-between the crops may be covered with reflective material such as white plastic sheets in order to increase the reflection of sunlight and maximize the energy impinging on the back side of the light collection arrangement.

According to an embodiment of the present invention, the light collection layer may include bypass diodes arranged in parallel to the one or multiple rows of photovoltaic cells. Bypass diodes can minimize electrical loss and cell damage due to partial shading of the light collection layer. Furthermore, the light collection layer may include blocking diodes at one end of each row of photovoltaic cells in order to minimize electric losses and cell damage due to partial shading of the light collection layer.

In yet another embodiment of the present invention, the light collection layer may include a transparent front plane oriented towards the optical layer, an encapsulation layer comprising the elongate photovoltaic cells arranged in rows substantially spaced by gaps, and a transparent backplane. Therefore, the photovoltaic cells can be sandwiched between the front plane configured as a first protective layer and the backplane configured as a second protective layer. Thanks to the encapsulation, the photovoltaic cells can be protected from stress and contaminants such as humidity and dust.

The front plane and/or the backplane can be made of tempered or chemically hardened glass for its rigidity and resistance to shocks. Alternatively, the front plane can also be made of tempered or chemically hardened glass, while the backplane is made of a sheet of polymer. Another alternative is that both the front plane and the backplane are made of polymer sheets to reduce weight and to create a more lightweight optomechanical system. Furthermore, the front plane and/or the backplane may include an anti-reflective coating to increase light collection by the photovoltaic cells and light transmission through the backplane of each light collection layer by minimizing the extent of reflection at the transitions between air to optical layer and vice versa.

In another embodiment of the present invention, the light collection layer may include a photoluminescent layer arranged at the front plane or at the backplane of the photovoltaic cells. Thanks to the photoluminescent layer the spectrum of light transmitted by the optomechanical system can be changed. This is advantageous in agriculture applications in order to transmit light with a spectrum optimized for the plants growing beneath and redirecting at least part of the light impinging on the gaps between the photovoltaic cells towards the solar cells to improve the light collection efficiency. Preferably, the photoluminescent layer is designed to substantially redirect green-shifted light of the incident light onto the light collection elements, which is not used for photosynthesis of the plants growing beneath the optomechanical system, and to transmit blue-shifted light below 450nm or red-shifted light above 650nm.

In one embodiment of the present invention, each optical layer of the optical arrangement comprises at least one type of optical elements either of reflective or more preferably of refractive type such as lenses including plano-convex, plano-concave, bi-convex or bi-concave, meniscus type and aspheric curvature having polynomial shape. Furthermore, the refractive optical layer may include single or bifacial Fresnel lenses. This allows for efficient concentration of the direct sunlight onto the light collection elements. Thanks to higher concentration through the optical elements, the efficiency of electricity production of the optomechanical system increases and due to smaller light collection elements, the surface of the light collection layer able to transmit diffuse light is larger, which improve the growing conditions of the crops placed below the system.

Each optical layer can be made of rolled glass, which offers high rigidity and low-cost, compression-molded acrylate (PMMA) or polycarbonate (PC), and/or casting of a silicone layer onto a glass substrate, which provide simple patterning and forming of the optical elements. Furthermore, the optical layers may include a single- or double-sided anti-reflective coating to increase electricity production of the light collection layer and to improve light transmission.

A second aspect, not being part of the present invention, relates to an optomechanical system for light regulation on plants and electricity production, comprising
an optical arrangement with a plurality of optical layers configured to focus direct sunlight;
a light collection arrangement with a plurality of light collection layers each comprising multiple distant elongate photovoltaic cells arranged in rows and substantially spaced by gaps,
wherein each optical layer is laminated on top of a corresponding light collection layer forming a translucent solar module,
a rotating axis to which an arrangement of at least one translucent solar module is attached;
a tracking mechanism to adjust light transmission and/or electricity production of the arrangement of the at least one translucent solar module by rotating the rotating axis to orient the arrangement substantially towards or away from the incident sunlight.

The tracking mechanism of the optomechanical system can be used to move the arrangement of the at least one translucent solar module by rotating around the rotating axis which can be arranged either on one side of the arrangement or in the middle. Thanks to that the tilt angle of the arrangement and therefore of the optomechanical system relative to the ground can be changed in particular during the day. The tracking mechanism comprising a single-axis tracker with the rotating axis enables positioning of the optomechanical system to maximize energy production and/or to adjust the transmission of light to fulfil the requirements for the crops and plants growing underneath the optomechanical system and/or put the optomechanical system in a vertical position to increase the space for agricultural machines.

For the sake of completeness, we would like to emphasize this second aspect can comprise further features and embodiments, in particular all those features disclosed in connection with the first aspect of the invention, as long as these features are compatible with features of the second aspect. Therefore, we herewith expressly declare that the present disclosure also comprises all such combination of features, although they have not been explicated.

### Brief description of the drawings

The foregoing and other objects, features and advantages of the present invention are apparent from the following detailed description taken in combination with the accompanying drawings in which:
Fig. 1A is a schematic cross-sectional view of an optomechanical system according to a first arrangement of the first embodiment of the present invention, where direct sunlight is impinging at normal incidence angle onto an optical layer of the optical array;
Fig. 1B is a schematic cross-sectional view of an optomechanical system according to a second arrangement of the first embodiment of the present invention;
Fig. 2A is a schematic top view of an optomechanical system with a centralized tracking system according to a second embodiment of the present invention;
Fig. 2B is a schematic cross-sectional view of an optomechanical system with the centralized tracking system according to the second embodiment of the present invention;
Fig. 3 is a schematic cross-sectional view of an optomechanical system with a centralized tracking system according to a third embodiment of the present invention;
Fig. 4A is a schematic top view of an optomechanical system with a centralized tracking system according to a fourth embodiment of the present invention;
Fig. 4B is a schematic cross-sectional view of an optomechanical system with the centralized tracking system according to the fourth embodiment of the present invention;
Fig. 5 is a schematic cross-sectional view of an optomechanical system with the centralized tracking system according to a fifth embodiment of the present invention;
Fig. 6A is a schematic cross-sectional view of a connecting element for releasably connecting multiple modules of an optomechanical system to the centralized tracking system in a clamping position;
Fig. 6B is a schematic cross-sectional view of the connecting element of Fig. 6A in an intermediate position;
Fig. 6C is a schematic cross-sectional view of the connecting element of Fig. 6A in a released clamping position;
Fig. 7A is a schematic cross-sectional view of an optomechanical system of a preferred embodiment with guiding elements designed as low-friction hinges attached to an intermediate frame element and indirectly to the optical layer;
Fig. 7B is a schematic cross-sectional view of an optomechanical system of a preferred embodiment with guiding elements designed as low-friction hinges attached directly to the optical layer;
Fig. 8 is a schematic cross-sectional view of an optomechanical system of a preferred embodiment with guiding elements designed as low-friction hinges, actuated by a centralized tracking system with a rod and a connecting element attached directly between the two axes of a low friction hinge;
Fig. 9A is a schematic top view of a light collection layer of an optomechanical system according to a preferred embodiment;
Fig. 9B is a schematic top view of light collection layers of an optomechanical system according to another preferred embodiment;
Fig. 10A is a schematic cross-sectional view of an optomechanical system integrated into a Venlo-type greenhouse roofing structure;
Fig. 10B is a schematic cross-sectional view of an optomechanical system integrated into an elevated open-structure above line cultures;
Fig. 11 is a schematic cross-sectional view of an active venting system to cool down an optomechanical system;
Fig. 12A illustrates the use of an optomechanical system according to the second aspect for agriculture application
Fig. 12B illustrates the use of the optomechanical system of Fig. 12A according to the second aspect in a different position.

### Detailed description of a preferred embodiment

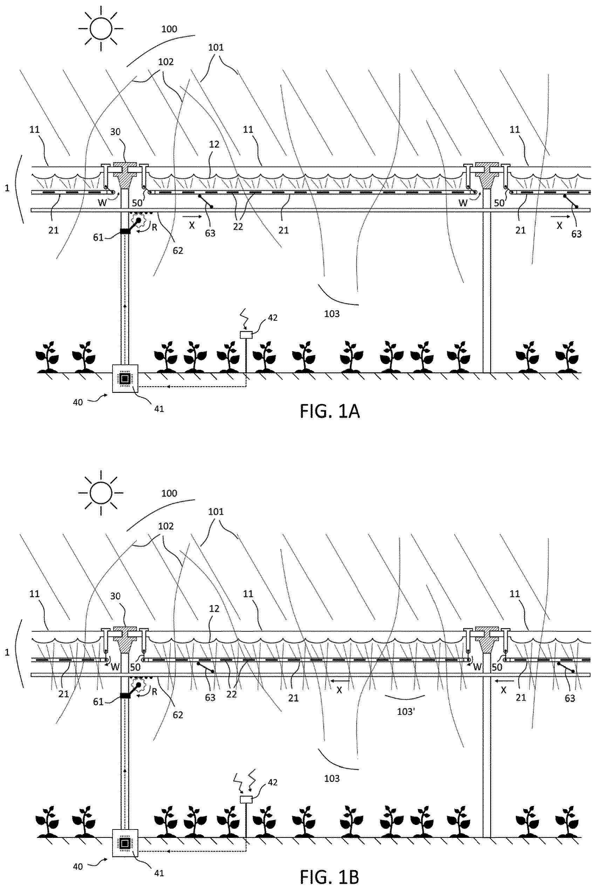

Figure 1A illustrates a photovoltaic optomechanical system 1 according to a first arrangement of a first embodiment of the present invention. As illustrated in Figure 1A, the optomechanical system 1 comprises several optical layers 11 as part of an optical arrangement 10 and several light collection layers 21 as part of a light collection arrangement 20. Displayed in Figure 1A, the optical layer 11 is designed to focus a direct component 101 of incident light or sunlight 100 onto light collection elements 22 of the corresponding light collection layer 21, i.e. onto elongate photovoltaic cells 22 placed on the transparent or translucent light collection layer 21. The shown optomechanical system 1 comprises a static frame 30 to which the optical layer 11 is attached and a tracking system 60, arranged to move the optical layer 11 relatively to the static frame 30, so that the amount of light energy converted by the light collection layer 21 and an amount of transmitted light 103 through this layer 21 can both be adjusted, depending on the relative position of the optical layer 11 and the light collection layer 21. As can be seen in Figure 1A, each optical layer 11 and its corresponding light collection layer 21 are connected together by guiding elements 50, which in this embodiment are designed as double low friction hinges. The guiding elements 50, an actuator 61 and the connecting elements 63 are parts of a tracking system 60. In this embodiment, the rotation R of the actuator 61 is transformed to a translation X of a translation element 62 by a rack and pinion system, which then pushes and pulls the translation element 62 so that the light collection layers 21 of the light collection arrangement 20, guided by the guiding elements 50, move along a quasi-circular trajectory W. The aim of the tracking system 60 is to translate each of the light collection layers 21 in a synchronized manner along the quasi-circular trajectory W, while preventing parasitic rotations between the optical arrangement 10 and the light collection arrangement 20. In particular, the tracking system 60 is configured such that it avoids any relative rotation perpendicular to the optomechanical system 1, between each optical layer 11 and its corresponding light collection layer 21. Alternative to the embodiment shown in Figure 1A, the optomechanical system 1 could provide for a movable optical layer 11.

The optical layer 11 is configured to focus the direct component of incident light 101, whereby the optical layer 11 can comprise multiple optical elements 12 of refractive or reflective type, such as lenses or reflectors. Furthermore, the optical layer 11 can comprise a single-sided or a double-sided anti-reflective coating to improve light transmission.

As depicted in Figure 1A, the optical elements 12 focus the direct component 101 of incident sunlight 100 to the light collection layer 21, i.e. onto the photovoltaic cells 22, while the diffuse component 102 of the incident sunlight 100 is at least partially transmitted through the light collection layer 21, allowing transmitted light 103 to arrive at the plants placed below the optomechanical system 1.

Figure 1B illustrates the optomechanical system 1 according to a second arrangement of the first embodiment of the present invention. In this second arrangement the tracking system 60 has moved each light collection layer 21 relative to the corresponding optical layer 11 via the translation element 62 and the connecting elements 63 due to rotation of the actuator 61 such that the amount of transmitted light 103 increases.

Furthermore, a control system 40 monitors the output of one or more sensor 42 and pilots the tracking system 60 in order to adjust the light transmission through the optomechanical system 1, based on a pre-defined algorithm or direct user inputs. The one or more sensor 42 can be for instance environmental sensors such as - but not limited to - irradiance sensors, temperature sensors, humidity sensors, or a combination thereof, providing feedback on the growth conditions of the plants cultivated below the optomechanical system 1. The one or more sensor 42 can also include current sensors, voltage sensors or power sensors, providing feedback on the electrical output of one or several light collection layers 21 of the light collection arrangement 20. The control system 40 monitors the sensor outputs and send commands to the tracking system 60 through an analog or digital bus (for instance LIN, CAN, etc.). The control system typically includes a micro-controller 41 in order to process sensor outputs and send commands to the tracking system 60. User inputs to the control system can be provided by means of a local or web-based interface (not shown here).

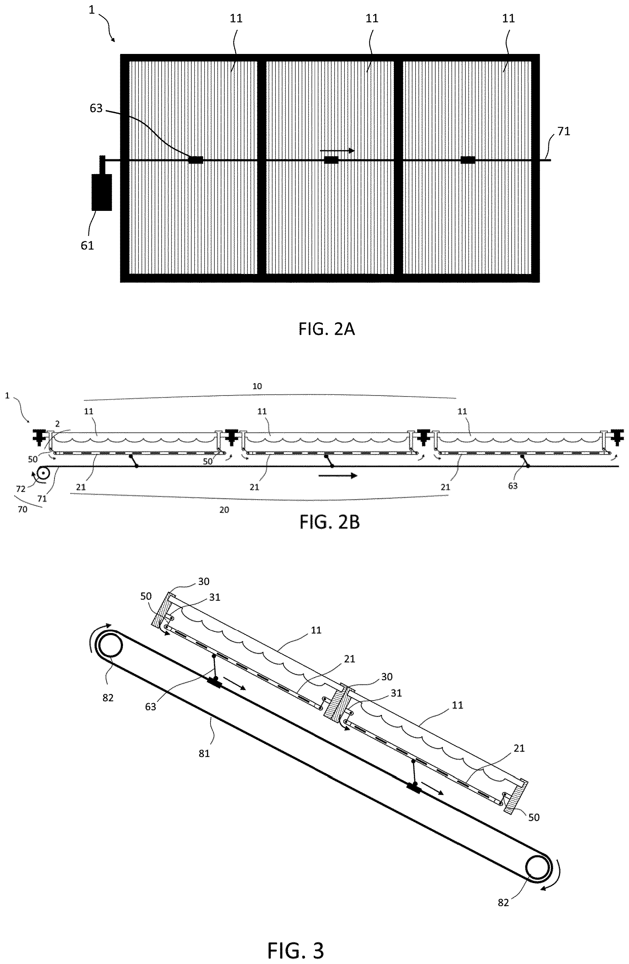

Figures 2A and 2B illustrates the optomechanical system 1 according to a second embodiment of the present invention including the optical arrangement 10 with a plurality of optical layers 11 and the light collection arrangement 20 with a plurality of light collection layers 21. The number of optical layers 11 is equal to the number of light collection layers 21. An optical layer 11 and a corresponding light collection layer 21 form a pair and in particular an at least partially transparent or translucent module 2. The optomechanical system 1 includes multiple translucent modules 2 connected together. The optomechanical system 1 illustrated in Figures 2A and 2B comprises three of these modules 2. Shown is a first embodiment of the optomechanical system 1 with the tracking system 60, configured as a cable drive system, in particular a cable and pulley system 70 for tracking the optomechanical system 1 to adjust the amount of electricity production and light transmission. The cable and pulley system 70 allows a single actuator 61 to control tracking of multiple modules 2 of the optomechanical system 1. The cable and pulley system 70 comprises at least one drive pulley 71 disposed on one side of the optomechanical system 1 and rotatable either manually by an end-user or by the at last one actuator 61. A cable 71 of the cable and pulley system 70 is at least wound around the drive pulley 72 and is attached to it at a first end. Along the cable 71 connecting elements 63 are arranged to preferably releasably connect the cable 71 to each of the modules 2, in particular as depicted to each of the light collection layers 21. A second end of the cable 71 can be attached to a tension device to return the displaced optical layer 21 or light collection layer 21 to an initial position. The connecting elements 63 are configured such that by pulling the cable 71 in either direction a relative translation between each optical layer 11 and the corresponding light collection layer 21 results and furthermore simultaneous for each module 2 of the optomechanical system 1. The displacement could range in magnitude but is limited to translation along one, two or three axes. Rotations are blocked or cancelled by means of the specific disposition of the guiding elements 50.

As illustrated in Figure 2B the schematic cross-section view of the optomechanical system 1, the tracking system 60 is designed as the cable and pulley system 70. Furthermore, each light collection layer 21 of the optomechanical system 1 is directly attached to the correspondent optical layer 11 by means of several guiding elements 50. In a preferred embodiment, the guiding elements 50 can be designed as double low-friction hinges 51 for a single-axis movement, and/or as double universal joints and/or as double ball-joints and/or double magnetic joints for a dual-axis movement. As illustrated in Figure 2B, the guiding elements 50 are designed in such a way that, when moved by the tracking system 60, in particular when the cable 71 of the cable and pulley system 70 is pulled to either direction represented by the horizontal arrow below, each light collection layer 21 moves along a curved trajectory represented by short arrows on corners of each collection layer 21. This curved trajectory is for instance a portion of a circular or quasi circular path. In other words, the linear movement of the cable 71 is transformed into a curved movement of the guiding elements 50, in particular along a circular trajectory around a rotating point of the hinge 51 connecting the guiding elements 50 directly or indirectly with the optical layer 11 or in another case with the light collection layer 21. The low-friction hinges 51 are designed to reduce or even cancel any friction accompanying the movement between the optical arrangement 10 and the light collection arrangement 20 of the optomechanical system 1.

As illustrated in Figure 3, a third embodiment of the optomechanical system 1 comprises the tracking system 60 designed as a pulley-and belt system 80 to control relative orientation of the optical arrangement 10 relative to the light collection arrangement 20. The pulley and belt system 80 includes a belt 81 linking two rotating pulleys 82 mechanically. At least one of the rotating pulleys 82 is rotated by the actuator 61 (not shown) such that the belt 81 is pulled in either direction. Connecting elements 63 are arranged to releasably connect the belt 81 with each of the light collection layers 21 of the light collection arrangement such that by pulling the belt 81 in either direction each light collection layer 21 is displaced translationally relative to the corresponding optical layer 11. By displacing simultaneously each light collection layer 21, the amount of the direct component of sunlight 102 transmitted through the optomechanical system 1 can be adjusted to meet the requirements of the plants growing underneath the optomechanical system 1.

In this third embodiment of the optomechanical system 1, the guiding element 50 is not directly arranged between the optical layer 11 and the light collection layer 21. The guiding element 50 is attached to an intermediate frame element 31 arranged or formed on the frame 30 to indirectly attach the light collection layer 21 to the corresponding layer 11 of one module 2 of the optomechanical system 1.

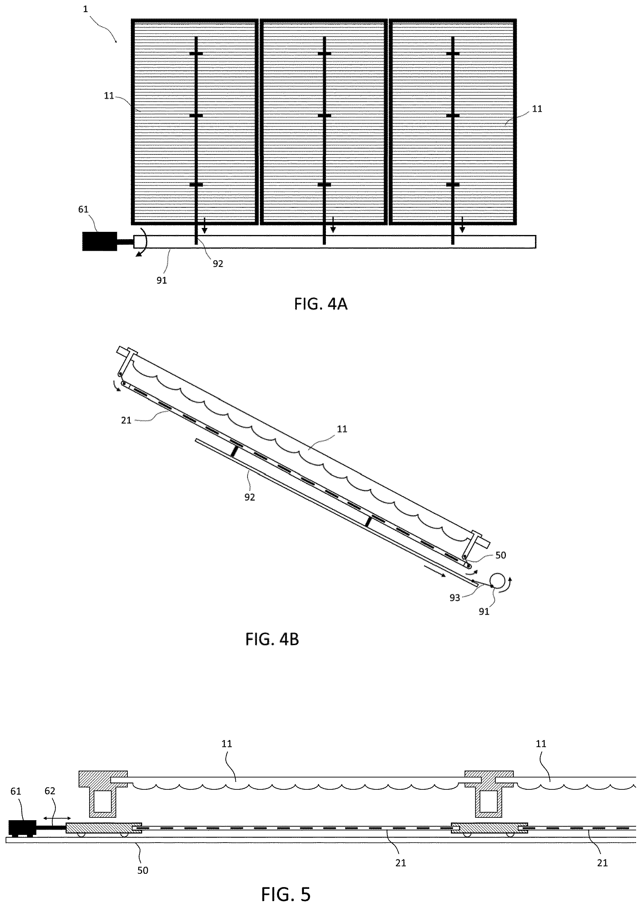

Figures 4A and 4B illustrate a fourth embodiment of the optomechanical system 1. In this fourth embodiment the tracking system 60 is designed as a rod assembly system 90. The rod assembly 90 includes a rotating axis 91, the at least one actuator 61 attached to one end of the rotating axis 91 and at least one connecting rod 92. The connecting rod 92 is attached with one end to the rotating axis 91 by connecting means 93. Furthermore, in the third embodiment shown in Figure 4B, the connecting rod 92 is attached to each light collection layer 21, advantageous at several points along the length of the connecting rod 92 such that by rotating the rotation rod 91 the connection rod 92 is displaced such that translation between the optical layer 11 and the correspondent light collection layer 21 results. The rotation of the rotation axis 91 is transformed into a relative translation.

Figure 5 shows a fifth embodiment of the optomechanical system 1, wherein several light collection layers 21 of the light collection arrangement 20 are attached together and guided on a planar trajectory by guiding elements 50 designed as a linear rail system. In this embodiment, the tracking system 60 is composed of an actuator 61 and translation element 62 arranged in such a way that the tracking system can push or pull the light collection arrangement along a single axis.

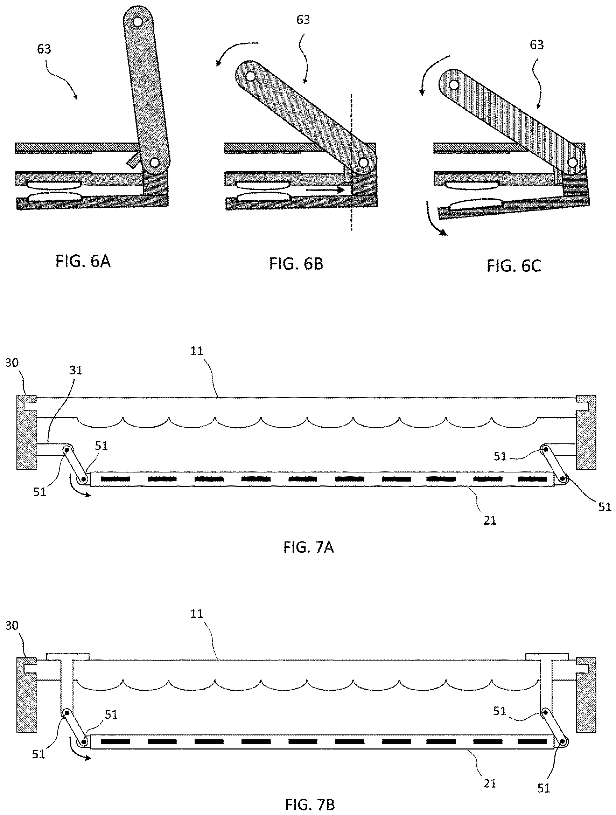

Figures 6A, 6B and 6C illustrate a preferred embodiment of the connecting elements 63 in different positions designed to be connectable to the translation element 62 of the tracking system 60 of the optomechanical system 1. The connecting element 63 is designed as a releasable clutch to provide a clamping mechanism, in particular to open the connection or attachment to the translation element 62 such as a cable, a belt, or rod, once a certain position is reached.

Figures 7A and 7B illustrate two types of attachment of the guiding elements 50 to the optomechanical system 1, wherein the guiding elements are designed as pairs of low-friction hinges 51. In Figure 7A, the guiding elements are attached indirectly between the optical layer 11 and the light collection layer 21. According to this Figure 7A, the optomechanical system 1 includes the frame 30 to which either the optical arrangement 10 or the light collection arrangement 20 is attached. The guiding elements 50 are connected to the frame 30 by means of intermediate frame elements 31, such as to guide the translation between the optical layer 11 and the correspondent light collection layer 21. In Figure 7B, the low-friction hinges 51 are attached directly between the optical layer 11 and the correspondent light collection layer 21. In the example shown, the low-friction hinge 51 is designed for a single axis movement and is attached through a hole provided in the optical layer 11.

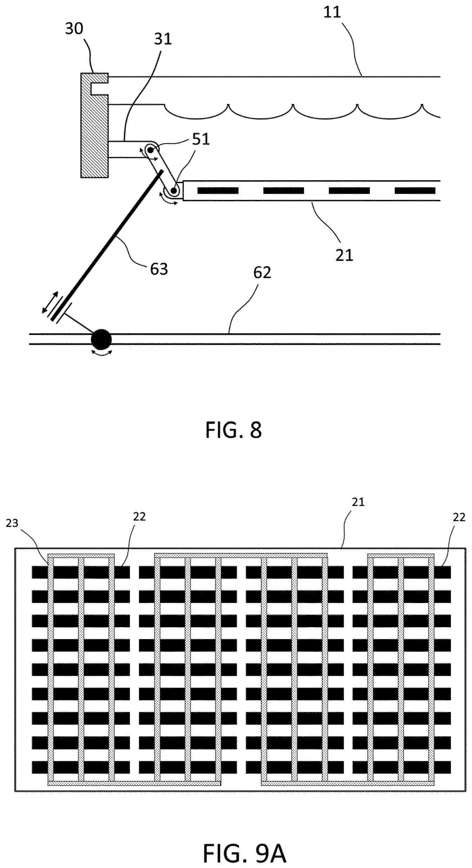

Figure 8 illustrates a preferred arrangement of the optomechanical system with guiding elements designed as pairs of low-friction hinges 51 and a tracking system comprising a translation element 62 designed as a rod, a cable or a belt, and one or more connecting elements 63, wherein the one or more connecting elements 63 are attached directly to the central part of one pair of low-friction hinges 51. In this embodiment, the connecting element 63 is fixed to the translation element 62 via a revolute joint and a prismatic joint. This embodiment is advantageous to decrease the actuation force required to shift the position of the optical arrangement or the light collection arrangement, thanks to the leverage provided by this specific mechanical arrangement.

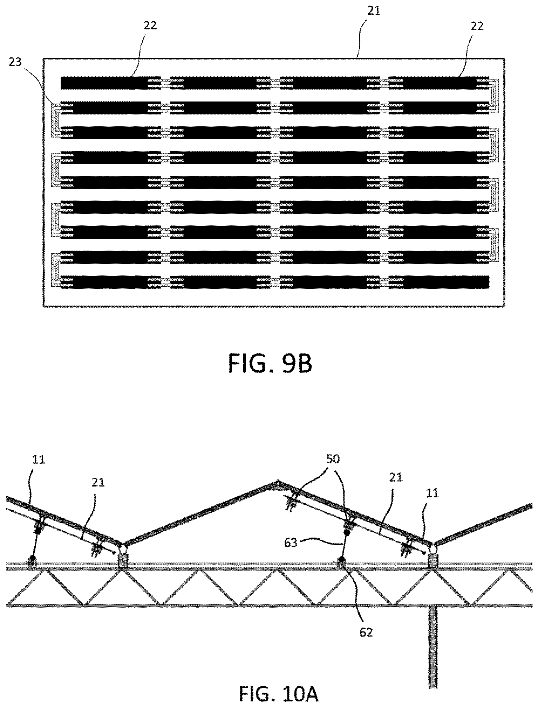

Figures 9A and 9B relate to a preferred embodiment of the optomechanical system 1 showing arrangements of the light collection elements such as elongate photovoltaic cells 22 on the transparent or translucent light collection layer 21 of the light collection arrangement 20. The photovoltaic cells 22 are arranged substantially in parallel rows spaced by gaps. To interconnect the multiple elongate photovoltaic cells 22 with each other connection lines 23 are provided such as ribbons, bus bars or etched conductive sheets forming a conductive circuit onto which the photovoltaic cells 22 are interconnected. In an advantageous arrangement the connection lines 23 are arranged such that a combination of series and parallel connections results in order to optimize the voltage and current output ranges of the optomechanical system 1. The connection lines 23 are preferably arranged along the length of the elongate photovoltaic cells 22 to minimize shading between the rows and therefore to optimize the amount of transmitted sunlight 103 used for photosynthesis of the plants growing underneath the optomechanical system 1.

Figure 9B shows an even more preferred embodiment wherein the connection lines 23 are arranged on a backside of the photovoltaic cells 22 and thereby on the opposite side of the solar cells facing the optical elements 12 of the optical layer 11. With this arrangement the shading on a front side of the photovoltaic cells 22 facing the optical elements 12 is minimized and therefore the light collection onto the elongate photovoltaic cells 22 is optimized and as a consequent thereof the electricity production increases.

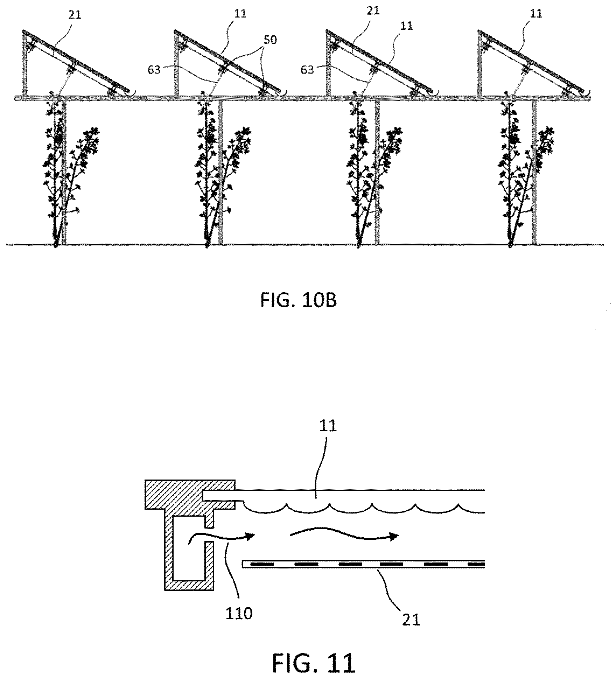

Figures 10A and 10B illustrate the integration of the optomechanical system 1 of the present invention onto two types of structures. On Figure 10A, the optomechanical system is integrated into a glasshouse roofing structure, such as a Venlo-type greenhouse, providing a controlled environment for the crops growing underneath. This roof structure can be provided with at least one, preferably asymmetric, roof section in particular a substantially south-facing roof section and an adjoining north-facing roof section, or alternatively with an east-facing roof section and an adjoining west-facing roof section. The roof sections are bounded by a gutter on one side and by a higher-positioned ridge on the opposite side. According to a preferred embodiment and depending on the orientation of the greenhouse roofing structure, optomechanical systems 1 may be integrated on the south-facing roof section, while the north-facing roof section is covered with conventional glass panes or vents. This arrangement is advantageous because the glasshouse structure is already optimized for cost and agronomic practices, therefore the integration of the optomechanical system is more straightforward and cost-effective.

With an east-west axis orientation of the greenhouse roofing, optomechanical systems 1 may be provided both on the east-facing roof section and on the west-facing roof section. This integration of optomechanical systems 1 on both east-facing and west-facing roof sections results in very high ratio of optomechanical system per meter square of ground, and therefore maximizes the energy production and light transmission through the optomechanical systems 1.

In a further preferred embodiment, each module 2 of the optomechanical system 1 is adapted in dimension to match the standard pitch between two Venlo-type greenhouse chapels such that on each side of the chapel one optomechanical system 1 can be integrated per roof section. This arrangement ensures that water condensation can be collected by the gutters on both ends of the optomechanical systems 1 and will not drip on crops below. Furthermore, edges of the optical layer 11 of the optical arrangement 10 including thickness and profile are designed to be compatible with conventional Venlo-type greenhouse clamping profiles. The good compatibility and easy integration of optomechanical systems 1 according to the present invention reduce costs and complexity of the supporting structure by using off-the-shelf components which are already proved in action.

Furthermore, the tracking system 60 of the optomechanical system 1 can be attached directly on the greenhouse supporting structure in an easy manner.

Figure 10B illustrates an alternative integration of the optomechanical system of the present invention on an elevated semi-open structure, which can typically be installed above line culture crops such as berries. This type of structure is advantageous for applications where a controlled climate is not required or where a more lightweight structure is desired. This type of open structure typically does not require concrete anchoring and is therefore suitable for installation on agricultural land.

Figure 11 illustrates another embodiment of the present invention, wherein cold air is ventilated through the profiles of the supporting structure to which the optomechanical systems 1 of the present invention are attached. The profiles include small openings on the side, in such a way that cold air 110 can be actively ventilated between the optical layers 11 of the optical arrangement 10 and the light collection layers 21 of the light collection arrangement 20, in order to cool the light collection arrangement and increase energy production. Cold air can be collected from outside or generated by an air conditioning system.

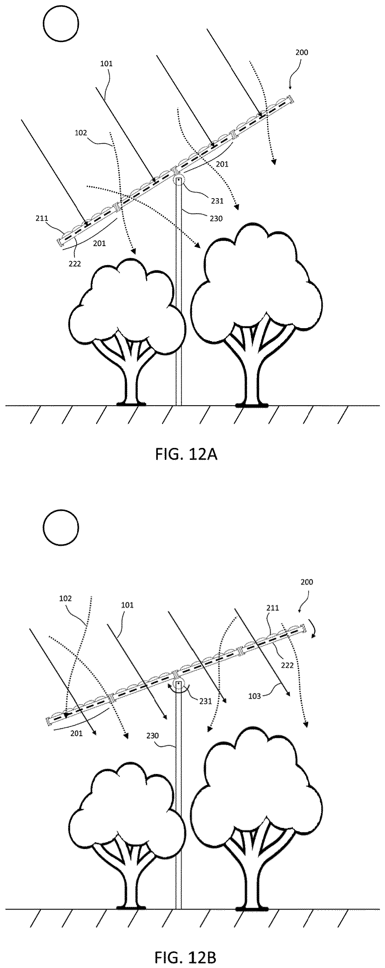

Figures 12A and 12B illustrate another aspect not being part of the invention. According to this aspect, an optomechanical system 200 comprises translucent solar modules 201. Each translucent solar module 201 is formed by an optical layer 211 laminated on top of a correspondent light collection layer 222. Each light collection layer 222 comprises multiple elongate photovoltaic cells arranged in a plurality of rows spaced from each other by gaps. Several translucent solar modules 201 are connected to form the optomechanical system 200. This optomechanical system 200 is mounted on a single-axis tracker 230, with a rotating axis 231.

On Figure 12A, the single-axis tracker is oriented in such a way that most of the direct sunlight 101 impinging on the optomechanical system 200 is focused by the optical layer 211 of each translucent solar module 201 on the elongated cells of the light collection layers 222. In this configuration, at least a portion of the diffuse sunlight 102 is transmitted through the translucent solar modules 201.

As illustrated on Figure 12B, only a small rotation of the single-axis tracker 230 is required to significantly change the amount of direct sunlight transmitted through the translucent solar modules 201. By slightly tilting the position of the optomechanical system 200, the angle of the direct sunlight 101 impinging on the translucent solar modules 201 changes, such that the amount of direct sunlight 103 transmitted to the plants growing underneath the optomechanical system 200 can be adjusted. This embodiment is advantageous compared to conventional single-axis tracker solutions, as only a small rotation is required to adjust the amount of direct sunlight used to produce electricity and the amount of direct sunlight transmitted to the crops. Furthermore, since the optomechanical system 200 is translucent and always transmits part of diffuse sunlight, the crops are never completely shaded as they would be under opaque solar modules.

## Claims

1. Optomechanical system (1) to regulate light transmission and electricity production, in particular in the field of agriculture, comprising
- an optical arrangement (10) with a plurality of optical layers (11), wherein each optical layer (11) comprises multiple optical elements (12) configured to focus a direct component of incident light (101) and to transmit a diffuse component of incident light (102);
- a light collection arrangement (20) with a plurality of light collection layers (21), wherein each light collection layer (21) is at least partially translucent to light (100) and comprises multiple distant elongate photovoltaic cells (22) arranged in rows and substantially spaced by gaps;
- at least one guiding element (50), attached to the optical arrangement (10) and/or the light collection arrangement (20), capable of providing a relative translation and suppressing any rotation between the optical arrangement (10) and the light collection arrangement (20);
- a centralized tracking system (60) configured to either displace the optical arrangement (10) or the light collection arrangement (20) along at least one axis such that at least part of a direct component of incident light (101) is directable onto the elongate photovoltaic cells (22) of the light collection arrangement (20) and at least a part of a diffuse component of incident light (102) is transmittable through the gaps between the rows of the elongate photovoltaic cells (22);
wherein the centralized tracking system (60) is configured to displace translationally either the optical arrangement (10) or the light collection arrangement (20) such that the amount of the direct component of the incident light (101) focused on the photovoltaic cells (22) and the amount of the direct component of incident light (101) transmitted through the optomechanical system (1) is adjustable; **characterized in that** the at least one guiding element (50) is configured to guide the movement of the optical arrangement (10) or the light collection arrangement (20) along a circular or a quasi-circular trajectory (W) and suppressing any rotation.

2. Optomechanical system (1) according to claim 1, wherein the at least one guiding element (50) is designed as a double low-friction hinge for a single-axis movement, and/or as a double universal joint and/or a double ball joint for dual-axis movement.

3. Optomechanical system (1) according to claim 2, wherein the at least one guiding element (50) is attached directly to the optical arrangement (10) and to the light collection arrangement (20).

4. Optomechanical system (1) according to claim 1, wherein the at least one guiding element (50) is designed as a rail and is configured to guide the movement of the optical arrangement (10) or the light collection arrangement (20) along a trajectory in a plane.

5. Optomechanical system (1) according to any one of the preceding claims, wherein multiple optical layers (11) and/or multiple light collection layers (21) are attached together by a frame or attachment element, and wherein the at least one guiding element (50) is connected to the frame or attachment element on one end, and to the optical arrangement (10) or the light collection arrangement (20) on the other end.

6. Optomechanical system (1) according to one of the preceding claims, wherein the centralized tracking system (60) comprises at least one elongated rod as a translation element (62) connected to one or more of the optical layers (11) or the light collection layers (21), such that the movement of the rod results in a relative translation between the optical arrangement (10) and the light collection arrangement (20), for example either directly by pushing or pulling, or via a rack and pinion system.

7. Optomechanical system (1) according to one of the claims 1 to 5, wherein the centralized tracking system (60) is configured as a cable and pulley system (70) such that by pulling the cable (71) in either directions a relative translation between the optical arrangement (10) and the light collection arrangement (20) results.

8. Optomechanical system (1) according to one of the claims 1 to 5, wherein the centralized tracking system (60) is configured as a pulley and belt system (80) such that moving the belt (81) in either directions result in a relative translation between the optical arrangement (10) and the light collection arrangement (20).

9. Optomechanical system (1) according to one of the claims 1 to 5, wherein the centralized tracking system (60) is configured as a rod assembly system (90) including a rotating axis (91) with at least one actuator (61) attached at one end of the rotating axis (91) and at least one connecting rod (92) attached with one end to the rotating axis (91) and attached to the optical arrangement (10) or the light collection arrangement (20) such that rotation of the rotation axis (91) is transformed into a relative translation between the optical arrangement (10) and the light collection arrangement (20).

10. Optomechanical system (1) according to one of the preceding claims, wherein the tracking system (60) comprises at least one actuator (61) configured as an electro-mechanical actuator, an electro-static actuator, a piezo-electrical actuator, a sick-slip actuator, or a pneumatic actuator.

11. Optomechanical system (1) according to one of the preceding claims, wherein the at least one connecting element (63) comprises a release mechanism such that the at least one connection element (63) can be detached from the translation element (62) at a pre-defined position and/or at a pre-defined angle.

12. Optomechanical system (1) according to one of the preceding claims, wherein the at least one connecting element (63) comprises a release mechanism such that the at least one connection element (63) can be detached from the translation element (62) above a certain level of force.

13. Optomechanical system (1) according to one of the preceding claims, wherein a blocking system is provided to block the movement of the connecting element (63) at a predefined position of the module.

14. Optomechanical system (1) according to one of the preceding claims, wherein the centralized tracking system (60) is piloted by a control system (40), either by direct end-user inputs through an human-machine interface, or indirectly based on an algorithm relying on external inputs collected through an interface or loaded from a memory.

## Patentansprüche

1. Optomechanisches System (1) zur Regelung der Lichttransmission und der Elektrizitätserzeugung, insbesondere im Bereich der Landwirtschaft, welches optomechanische System (1)
- eine optische Anordnung (10) mit einer Vielzahl von optischen Schichten (11), wobei jede optische Schicht (11) mehrere optische Elemente (12) umfasst, die so konfiguriert sind, dass sie eine direkte Komponente des einfallenden Lichts (101) fokussieren und eine diffuse Komponente des einfallenden Lichts (102) übertragen;
- eine Lichtsammelanordnung (20) mit einer Vielzahl von Lichtsammelschichten (21), wobei jede Lichtsammelschicht (21) zumindest teilweise lichtdurchlässig (100) ist und mehrere beabstandete längliche Solarzellen (22) umfasst, die in Reihen angeordnet und im Wesentlichen durch Lücken beabstandet sind;
- mindestens ein Führungselement (50), das an der optischen Anordnung (10) und/oder der Lichtsammelanordnung (20) befestigt ist, und welches Führungselement (50) eingerichtet ist, eine relative Verschiebung zwischen der optischen Anordnung (10) und der Lichtsammelanordnung (20) zu bewirken und jede Drehung zwischen der optischen Anordnung (10) und der Lichtsammelanordnung (20) zu unterdrücken; und
- ein zentrales Verstellsystem (60), das konfiguriert ist, entweder die optische Anordnung (10) oder die Lichtsammelanordnung (20) entlang mindestens einer Achse derart zu verfahren, dass mindestens ein Teil einer direkten Komponente des einfallenden Lichts (101) auf die länglichen Solarzellen (22) der Lichtsammelanordnung (20) richtbar ist und mindestens ein Teil einer diffusen Komponente des einfallenden Lichts (102) die Lücken zwischen den Reihen der länglichen Solarzellen (22) der Lichtsammelanordnung (20) passieren kann;
umfasst, wobei das zentrale Verstellsystem (60) konfiguriert ist, entweder die optische Anordnung (10) oder die Lichtsammelanordnung (20) translational zu verschieben, so dass die Menge der direkten Komponente des einfallenden Lichts (101), die auf die photovoltaischen Zellen (22) fokussiert wird und die Menge der direkten Komponente des einfallenden Lichts (101), die das optomechanische System (1) passieren kann, einstellbar ist;
**dadurch gekennzeichnet, dass** das mindestens eine Führungselement (50) konfiguriert ist, die Bewegung der optischen Anordnung (10) oder der Lichtsammelanordnung (20) entlang einer kreisförmigen oder quasikreisförmigen Bahn (W) zu führen und jegliche Rotation zu unterbinden.

2. Optomechanisches System (1) nach Anspruch 1, wobei das mindestens eine Führungselement (50) als doppeltes reibungsarmes Scharnier für eine einachsige Bewegung und/oder als Doppelkreuzgelenk und/oder als Doppelkugelgelenk für zweiachsige Bewegungen ausgebildet ist.

3. Optomechanisches System (1) nach Anspruch 2, wobei das mindestens eine Führungselement (50) direkt an der optischen Anordnung (10) und an der Lichtsammelanordnung (20) angebracht ist.

4. Optomechanisches System (1) nach Anspruch 1, wobei das mindestens eine Führungselement (50) als Schiene ausgebildet und eingerichtet ist, die Bewegung der optischen Anordnung (10) oder der Lichtsammelanordnung (20) entlang einer Trajektorie in einer Ebene zu führen.

5. Optomechanisches System (1) nach einem der vorhergehenden Ansprüche, wobei mehrere optische Schichten (11) und/oder mehrere Lichtsammelschichten (21) durch einen Rahmen oder ein Befestigungselement miteinander verbunden sind, und wobei das mindestens eine Führungselement (50) an einem Ende mit dem Rahmen oder Befestigungselement und am anderen Ende mit der optischen Anordnung (10) oder der Lichtsammelanordnung (20) verbunden ist.

6. Optomechanisches System (1) nach einem der vorhergehenden Ansprüche, wobei das zentrale Verstellsystem (60) mindestens einen länglichen Stab als Translationselement (62) umfasst, der mit einer oder mehreren der optischen Schichten (11) oder der Lichtsammelschichten (21) verbunden ist, so dass die Bewegung des Stabes eine relative Translation zwischen der optischen Anordnung (10) und der Lichtsammelvorrichtung (20) bewirkt, beispielsweise entweder direkt durch Schieben oder Ziehen oder über ein Zahnrad-Zahnstange-System.

7. Optomechanisches System (1) nach einem der Ansprüche 1 bis 5, wobei das zentrale Verstellsystem (60) als Seil- und Rollensystem (70) ausgebildet ist, wobei durch Ziehen am Kabel (71) in beide Richtungen eine relative Verschiebung zwischen der optischen Anordnung (10) und der Lichtsammelanordnung (20) erfolgt.

8. Optomechanisches System (1) nach einem der Ansprüche 1 bis 5, wobei das zentrale Verstellsystem (60) als Riemenscheibensystem ausgebildet ist, wobei eine Bewegung des Bandes (81) in beiden Richtungen zu einer relativen Verschiebung zwischen der optischen Anordnung (10) und dem Lichtsammelanordnung (20) führt.

9. Optomechanisches System (1) nach einem der Ansprüche 1 bis 5, wobei das zentrale Verstellsystem (60) als Stabsystem (90) ausgebildet ist, das eine Drehachse (91) mit mindestens einem, an einem Ende der Drehachse (91) angebrachten, Aktuator (61) und mindestens einen, mit einem Ende an der Drehachse (91) angebrachten und an der optischen Anordnung (10) oder der Lichtsammelanordnung (20) derart, dass eine Rotation der Drehachse (91) in eine relative Bewegung zwischen der optischen Anordnung (10) und der Lichtsammelanordnung (20) umgesetzt wird, befestigten Verbindungsstab (92) beinhaltet.

10. Optomechanisches System (1) nach einem der vorhergehenden Ansprüche, wobei das Verstellsystem (60) mindestens einen Aktuator (61) umfasst, der als elektromechanischer Aktuator, elektrostatischer Aktuator, piezoelektrischer Aktuator, Stick-Slip-Aktuator oder pneumatischer Aktuator ausgebildet ist.

11. Optomechanisches System (1) nach einem der vorhergehenden Ansprüche, wobei das mindestens eine Verbindungselement (63) einen Lösemechanismus umfasst, so dass das mindestens eine Verbindungselement (63) an einer vordefinierten Position und/oder in einem vordefinierten Winkel von dem Translationselement (62) gelöst werden kann.

12. Optomechanisches System (1) nach einem der vorhergehenden Ansprüche, wobei das mindestens eine Verbindungselement (63) einen Lösemechanismus umfasst, so dass das mindestens eine Verbindungselement (63) ab einem bestimmten Kraftniveau von dem Translationselement (62) gelöst werden kann.

13. Optomechanisches System (1) nach einem der vorhergehenden Ansprüche, wobei ein Blockiersystem vorgesehen ist, um die Bewegung des Verbindungselements (63) an einer vordefinierten Position des Moduls zu blockieren.

14. Optomechanisches System (1) nach einem der vorhergehenden Ansprüche, wobei das zentrale Verstellsystem (60) von einem Steuersystem (40), entweder durch direkte Eingaben des Endnutzers über eine Mensch-Maschine-Schnittstelle oder indirekt auf Grundlage eines Algorithmus, der sich auf externe Eingaben stützt, die über eine Schnittstelle erfasst oder aus einem Speicher geladen werden, gesteuert wird.

## Revendications

1. Système optomécanique (1) pour réguler la transmission de la lumière et la production d'électricité, en particulier dans le domaine de l'agriculture, comprenant
- un arrangement optique (10) avec plusieurs couches optiques (11), dans lequel chaque couche optique (11) comprend plusieurs éléments optiques (12) configurés pour focaliser une composante directe de la lumière incidente (101) et pour transmettre une composante diffuse de la lumière incidente (102) ;
- un arrangement de collecte de lumière (20) avec plusieurs couches de collecte de lumière (21), dans lequel chaque couche de collecte de lumière (21) est au moins partiellement translucide à la lumière (100) et comprend de multiples cellules photovoltaïques (22) allongées et distantes disposées en rangées et substantiellement espacées par des espaces ;
- au moins un élément de guidage (50), attaché à l'arrangement optique (10) et/ou à l'arrangement de collecte de lumière (20), capable de fournir une translation relative et de supprimer toute rotation entre l'arrangement optique (10) et l'arrangement de collecte de lumière (20) ;
- un système centralisé de suivi (60) configuré pour déplacer l'arrangement optique (10) ou l'arrangement de collecte de lumière (20) le long d'au moins un axe de sorte qu'au moins une partie d'une composante directe de la lumière incidente (101) puisse être dirigée sur les cellules photovoltaïques allongées (22) de l'arrangement de collecte de lumière (20) et qu'au moins une partie d'une composante diffuse de la lumière incidente (102) puisse être transmise à travers les espaces entre les rangées de cellules photovoltaïques allongées (22) ;
dans lequel le système centralisé de suivi (60) est configuré pour déplacer translationnellement soit l'arrangement optique (10) soit l'arrangement de collecte de lumière (20) de sorte que la quantité de la composante directe de la lumière incidente (101) focalisée sur les cellules photovoltaïques (22) et la quantité de la composante directe de la lumière incidente (101) transmise à travers le système optomécanique (1) sont réglables ; **caractérisé en ce qu'**au moins un élément de guidage (50) est configuré pour guider le mouvement de l'arrangement optique (10) ou de l'arrangement de collecte de lumière (20) le long d'une trajectoire circulaire ou quasi-circulaire (W) et en supprimant toute rotation.

2. Système optomécanique (1) selon la revendication 1, dans lequel l'au moins un élément de guidage (50) est conçu comme une double charnière à faible friction pour un mouvement sur un seul axe, et/ou comme un joint double universel et/ou une rotule double pour un mouvement sur deux axes.

3. Système optomécanique (1) selon la revendication 2, dans lequel le au moins un élément de guidage (50) est attaché directement à l'arrangement optique (10) et à l'arrangement de collecte de lumière (20).

4. Système optomécanique (1) selon la revendication 1, dans lequel l'au moins un élément de guidage (50) est conçu comme un rail et est configuré pour guider le mouvement de l'arrangement optique (10) ou de l'arrangement de collecte de lumière (20) le long d'une trajectoire dans un plan.

5. Système optomécanique (1) selon l'une quelconque des revendications précédentes, dans lequel plusieurs couches optiques (11) et/ou plusieurs couches de collecte de lumière (21) sont attachées ensemble par un cadre ou un élément de fixation, et dans lequel au moins un élément de guidage (50) est relié au cadre ou à l'élément de fixation à une extrémité, et à l'arrangement optique (10) ou à l'arrangement de collecte de lumière (20) à l'autre extrémité.

6. Système optomécanique (1) selon l'une des revendications précédentes, dans lequel le système centralisé de suivi (60) comprend au moins une tige élongée comme élément de translation (62) reliée à une ou plusieurs des couches optiques (11) ou des couches de collecte de lumière (21), de sorte que le mouvement de la tige entraîne une translation relative entre l'arrangement optique (10) et l'arrangement de collecte de lumière (20), par exemple soit directement en poussant ou en tirant, soit par l'intermédiaire d'un système de crémaillère et de pignon.

7. Système optomécanique (1) selon l'une des revendications 1 à 5, dans lequel le système centralisé de suivi (60) est configuré comme un système de câble et de poulie (70) de sorte qu'en tirant le câble (71) dans l'une ou l'autre des directions, il en résulte une translation relative entre l'arrangement optique (10) et l'arrangement de collecte de la lumière (20).

8. Système optomécanique (1) selon l'une des revendications 1 à 5, dans lequel le système centralisé de suivi (60) est configuré comme un système de poulie et de courroie (80) de sorte que le déplacement de la courroie (81) dans l'une ou l'autre des directions entraîne une translation relative entre l'arrangement optique (10) et l'arrangement de collecte de la lumière (20).

9. Système optomécanique (1) selon l'une des revendications 1 à 5, dans lequel le système centralisé de suivi (60) est configuré comme un système d'assemblage de tiges (90) comprenant un axe de rotation (91) avec au moins un actionneur (61) fixé à une extrémité de l'axe de rotation (91) et au moins une tige de connexion (92) fixée à une extrémité de l'axe de rotation (91) et fixée à l'arrangement optique (10) ou à l'arrangement de collecte de lumière (20) de telle sorte que la rotation de l'axe de rotation (91) est transformée en une translation relative entre l'arrangement optique (10) et l'arrangement de collecte de lumière (20).

10. Système optomécanique (1) selon l'une des revendications précédentes, dans lequel le système centralisé de suivi (60) comprend au moins un actionneur (61) configuré comme un actionneur électromécanique, un actionneur électrostatique, un actionneur piézo-électrique, un actionneur stick-slip, ou un actionneur pneumatique.

11. Système optomécanique (1) selon l'une des revendications précédentes, dans lequel au moins un élément de liaison (63) comprend un mécanisme de déclenchement tel que le au moins un élément de liaison (63) peut être détaché de l'élément de translation (62) à une position prédéfinie et/ou à un angle prédéfini.

12. Système optomécanique (1) selon l'une des revendications précédentes, dans lequel le au moins un élément de liaison (63) comprend un mécanisme de déclenchement tel qu'au moins un élément de liaison (63) peut être détaché de l'élément de translation (62) au-delà d'un certain niveau de force.

13. Système optomécanique (1) selon l'une des revendications précédentes, dans lequel un système de blocage est prévu pour bloquer le mouvement de l'élément de connexion (63) à une position prédéfinie du module.

14. Système optomécanique (1) selon l'une des revendications précédentes, dans lequel le système de suivi centralisé (60) est piloté par un système de contrôle (40), soit par des entrées directes de l'utilisateur final par le biais d'une interface homme-machine, soit indirectement sur la base d'un algorithme reposant sur des entrées externes collectées par le biais d'une interface ou chargées à partir d'une mémoire.
